# FASCICULE DE BREVET EUROPEEN

(11) **EP 1 066 926 B1**
(45) Date de publication et mention de la délivrance du brevet: **29.03.2006**
(21) Numéro de dépôt: 00401691.1
(22) Date de dépôt: 15.06.2000
(51) Int. Cl.: B24B 37/04, H01S 3/08, H01L 21/304, B08B 7/04

(54) **Procédé de polissage d'au moins une surface d'une pièce à base de silicium**
Verfahren zum Polieren von mindestens einer Seite eines Silizium enthaltende Werkstücks
Method of polishing at least one face of a silicium based workpiece

(30) Priorité: 28.06.1999 FR 9908228
(43) Date de publication de la demande: 10.01.2001
(73) Titulaire: SOCIETE EUROPEENNE DE SYSTEMES OPTIQUES S.E.S.O., 13792 Aix-en-Provence Cedex 3 (FR)
(72) Inventeur: Ferme, Jean-Jacques, 13880 Velaux (FR); Godefroy, Philippe, 13006 Marseille (FR); Dahan, Gilbert, 13100 Aix-en-Provence (FR)
(74) Mandataire: Jacquard, Philippe Jean-Luc

(56) Documents cités:
- EP-A- 0 692 318
- EP-A- 0 849 039
- US-A- 4 867 803
- US-A- 5 704 987
- US-A- 5 775 980

## Description

La présente invention a pour objet un procédé de polissage d'au moins une surface d'une pièce à base de silicium, et qui est en SiO₂, en SiC, en verre, en quartz ou bien encore en vitro-céramique.

On connaît déjà des procédés de polissage qui mettent en oeuvre un doucissage qui est un pré-polissage réalisé à l'aide d'au moins un élément de doucissage, par exemple une plaque en fonte et un abrasif, par exemple un émeri, pour conférer à ladite surface une première rugosité dite grossière, suivi d'un polissage mettant en oeuvre au moins un élément de polissage par exemple un support en polyuréthane ou de la poix, et un liquide contenant un abrasif, et notamment un oxyde abrasif, par exemple un oxyde de cérium ou de zirconium, pour conférer à ladite surface une deuxième rugosité inférieure à ladite première rugosité.

De tels procédés permettent d'obtenir des surfaces de haut degré de polissage dont ladite deuxième rugosité est inférieure à 10 Å et est de l'ordre de quelques Å.

La Demanderesse a cependant constaté qu'en dépit de cet état de surface de haute qualité, les pièces réalisées selon ces procédés connus présentaient une tenue au flux qui n'est pas satisfaisante.

La tenue au flux représente la quantité d'énergie que peut recevoir une surface avant de subir un éclatement. On peut la mesurer notamment à l'aide d'un laser pulsé émettant des impulsions de longueur d'onde et de durée données. Elle s'exprime alors en J/cm². Elle s'exprime en W/cm² pour des lasers continus.

La présente invention repose sur l'idée selon laquelle la tenue au flux non satisfaisante d'une telle pièce à base de silicium polie par les procédés connus est due en particulier à la contamination de la surface par des résidus abrasifs exogènes (par exemple oxyde de cérium ou de zirconium), qui subsistent après polissage. En outre, les surfaces obtenues par les procédés connus sont également susceptibles de présenter des micro-fractures qui en diminuent également la tenue au flux.

L'invention a pour objet d'améliorer la tenue au flux de la surface de telles pièces à base de silicium, et à cet effet, elle est caractérisée en ce qu'après doucissage et polissage elle présente une finition par abrasion douce mettant en oeuvre au moins un élément de finition, notamment un feutre, et un abrasif doux, constitué notamment par de la silice colloïdale, pour enlever une couche superficielle d'épaisseur suffisante pour améliorer la tenue au flux de ladite pièce, ladite épaisseur étant au moins égale à 1µ.

Au cours de cette étape, la rugosité n'est pas nécessairement améliorée, en particulier pour des pièces pour lesquelles une amélioration de la valeur de la tenue au flux est spécifiquement recherchée, par exemple des pièces en silice pour lasers de puissance. On notera cependant que le procédé selon l'invention permet si besoin est d'obtenir une rugosité améliorée pouvant être de l'ordre de 1Å.

Lorsque la pièce est une pièce plane, le procédé est de manière préférentielle mis en oeuvre par polissage double face de deux faces planes parallèles et opposées de ladite pièce plane, même si un état de surface de qualité élevée n'est requis que pour une seule face de la pièce.

La description qui va suivre va permettre de mieux comprendre l'invention en l'expliquant à l'aide d'exemples de mise en oeuvre, donnés à titre non limitatif.

Le doucissage, le polissage, et la finition sont réalisés sur trois postes successifs. Pour un usinage plan double face, on pourra utiliser par exemple des machines double face commercialisées par la Société STRASBAUGH, 825 Buchly Road, San Luis Obispo, CA 93401 (USA), ou bien par la Société PR HOFFMAN MACHINE PRODUCTS, 1517 Commerce Avenue, Carlish, PA 17013 (USA).

Le doucissage des pièces est réalisé en équipant une machine double face de plateaux en fonte et en utilisant un émeri comme abrasif. La vitesse de rotation des plateaux supérieur et inférieur est de l'ordre de 20 à 30 tours/min. La ou les pièces sont portées par un satellite animé d'une rotation et dont l'axe est excentré par rapport à l'axe des plateaux, avec une vitesse de rotation de l'ordre de 20 tours/min. Cette étape permet d'enlever par abrasion une couche d'environ 200µ à 500µ.

Le polissage des pièces est réalisé en équipant une machine double face de plateaux en polyuréthane ayant une vitesse de rotation de l'ordre de 20 tours/min et en mettant en oeuvre un oxyde de cérium ou de zirconium à titre d'abrasif, cet oxyde étant mis en suspension aqueuse. La ou les pièces sont portées par un satellite animé d'une rotation et dont l'axe est excentré par rapport à l'axe des plateaux, avec une vitesse de rotation de l'ordre de 20 tours/min. Ce polissage permet d'enlever au bout d'une heure une couche dont l'épaisseur est d'environ 10µ à 50µ, et d'obtenir des surfaces ayant une rugosité de l'ordre de quelques Å. Le polissage peut être également réalisé avec de la poix.

D'une manière générale, les conditions du doucissage et de polissage utilisées dans l'Art Antérieur peuvent convenir dans le cadre du procédé selon l'invention.

La finition des pièces par abrasion douce peut être réalisée sur une machine double face équipée de deux éléments de finition, par exemple en feutre, tournant à des vitesses de l'ordre de 20 à 30 tours/min., l'abrasif étant une silice colloïdale contenant des particules de silice de taille homogène. Cette taille des particules est de préférence comprise entre 0,03µ et 0,1µ. La pression d'abrasion appliquée à la surface par les éléments de finition peut être est comprise entre 10 et 100 g/cm². La ou les pièces sont portées par un satellite animé d'une rotation et dont l'axe est excentré par rapport à l'axe des plateaux, avec une vitesse de rotation de l'ordre de 20 à 30 tours/min. Au cours de cette finition, on enlève par abrasion entre 1µ et 3µ de matière ou plus, la valeur préférée étant de l'ordre de 3µ.

Dans la mesure où on recherche spécifiquement l'amélioration de la tenue au flux (par exemple pièces en SiO₂ pour lasers de puissance, notamment dans le cadre du programme MEGAJOULE du Commissariat à l'Energie Atomique (CEA) et de la « National Ignition Facility» (NIF) du « Lawrence Livermore National Laboratory » (LLNL)), il n'est pas nécessaire d'améliorer la rugosité par rapport à la valeur obtenue après le polissage (deuxième rugosité de l'ordre de quelques Å, par exemple 3 à 5 Å).

Le procédé selon l'invention a ainsi permis d'obtenir des surfaces en SiO₂ polies ayant, pour des impulsions fournies par un laser YAG triplé à 0,355µm avec une durée d'impulsion de 4 ns une tenue au flux au moins égale à 20 J/cm² à comparer avec des valeurs comprises entre 13 et 15 J/cm² avec les procédés connus.

Une autre expérience réalisée avec un laser à excimère délivrant des impulsions à 0,10µm avec une durée d'impulsion de 15 ns a permis d'obtenir, avec une surface préparée selon l'invention, une tenue au flux au moins égale à 13 J/ cm² au lieu de 4 J /cm² avec un procédé connu.

Le procédé permet cependant, notamment en choisissant une silice de granulométrie fine (par exemple 0,03µ) d'obtenir des surfaces de très faible rugosité (par exemple de l'ordre de 1 Å).

Le procédé se prête également à la réalisation de pièces de grandes dimensions par exemple plusieurs centaines de mm, et en particulier à des pièces circulaires de plusieurs centaines de mm de diamètre.

Pour des pièces planes, il est plus avantageux de mettre en oeuvre le procédé en utilisant des machines de polissage double face même si le polissage n'est requis que pour une seule face, car le résultat est obtenu de manière plus rapide en utilisant cette technique.

Par ailleurs, le polissage permet d'obtenir deux surfaces opposées qui présentent un très bon parallélisme, une très bonne planéité et une très bonne rugosité, ainsi qu'une tenue améliorée au flux.

## Revendications

1. Procédé de polissage d'au moins une surface d'une pièce à base de silicium qui est soit en SiO₂, soit en SiC, soit en verre, soit en vitro-céramique, soit en quartz, et comportant :
a) un doucissage mettant en oeuvre au moins un élément de doucissage et un abrasif, pour conférer à ladite surface une première rugosité ;
b) un polissage mettant en oeuvre au moins un élément de polissage et un liquide contenant un abrasif de polissage pour conférer à ladite surface une deuxième rugosité inférieure à la première rugosité ;
**caractérisé en ce qu'**il comporte :
c) une finition par abrasion douce mettant en oeuvre au moins un élément de finition, notamment un feutre, et un abrasif doux, pour enlever une couche superficielle d'épaisseur suffisante pour améliorer la tenue au flux de la pièce, ladite épaisseur étant au moins égale à 1µ.

2. Procédé selon la revendication 1, **caractérisé en ce que** l'élément de doucissage est un plateau de fonte et **en ce que** l'abrasif est un émeri.

3. Procédé selon une des revendications 1 ou 2, **caractérisé en ce que** l'élément de polissage est un plateau en polyuréthane ou de la poix et **en ce que** l'abrasif est un oxyde, notamment de cérium ou de zirconium.

4. Procédé selon une des revendications précédentes, **caractérisé en ce que** l'abrasif doux est constitué par de la silice colloïdale.

5. Procédé selon la revendication 4, **caractérisé en ce que** la silice colloïdale présente des particules de taille comprise entre 0,03µ et 0,1 µ.

6. Procédé selon une des revendications précédentes, **caractérisé en ce que** la pièce à base de silicium est une pièce plane et **en ce que** le doucissage, le polissage et la finition sont réalisés sur deux faces planes parallèles et opposés de ladite pièce plane.

7. Procédé selon une des revendications précédentes, **caractérisé en ce que** ladite deuxième rugosité est inférieure à 10 Å

8. Procédé selon une des revendications précédentes, **caractérisé en ce que** la finition est conduite de manière à conférer à ladite surface une troisième rugosité inférieure à la ladite deuxième rugosité.

9. Procédé selon une des revendications précédentes, **caractérisé en ce que** ledit polissage met en oeuvre l'enlèvement d'une couche d'épaisseur comprise entre 10µ et 50µ.

## Patentansprüche

1. Verfahren zum Polieren mindestens einer Oberfläche eines auf Silizium basierenden Werkstücks aus entweder SiO₂ oder SiC oder Glas oder Glaskeramik oder Quarz, welches umfaßt:
a) ein Klarschleifen unter Verwendung von mindestens einem Klarschleifelement und einem Klarschleifmittel, um der Oberfläche eine erste Rauhigkeit zu verleihen;
b) ein Polieren unter Verwendung von mindestens einem Polierelement und einer Flüssigkeit, welche ein Polierabrasiv enthält, um der Oberfläche eine zweite Rauhigkeit zu verleihen, die geringer als die erste Rauhigkeit ist;
**dadurch gekennzeichnet, daß** das Verfahren umfaßt:
c) eine Feinbearbeitung mittels einer schwachen Abrasion unter Verwendung von mindestens einem Feinbearbeitungsmittel, insbesondere einem Filz, und einem schwachen Abrasiv, um eine Oberflächenschicht mit einer Dicke abzunehmen, die ausreicht, um die Laserfestigkeit des Werkstücks zu verbessern, wobei diese Dicke mindestens gleich 1 µm ist.

2. Verfahren nach Anspruch 1, **dadurch gekennzeichnet, daß** das Klarschleifelement eine Gußeisenplatte ist, und daß das Abrasiv ein Schmirgel ist.

3. Verfahren nach einem der Ansprüche 1 oder 2, **dadurch gekennzeichnet, daß** das Polierelement eine Platte aus Polyurethan oder Pech ist, und daß das Abrasiv ein Oxid, insbesondere von Cer oder Zirconium, ist.

4. Verfahren nach einem der vorhergehenden Ansprüche, **dadurch gekennzeichnet, daß** das Abrasiv aus kolloidalem Silicamaterial besteht.

5. Verfahren nach Anspruch 4, **dadurch gekennzeichnet, daß** das kolloidale Silicamaterial Partikel mit einer Größe von zwischen 0,03 µm und 0,1 µm aufweist.

6. Verfahren nach einem der vorhergehenden Ansprüche, **dadurch gekennzeichnet, daß** das auf Silizium basierende Werkstück ein planes Werkstück ist, und daß das Klarschleifen, das Polieren und die Feinbearbeitung an zwei parallelen und einander gegenüberliegenden planen Oberflächen des planen Werkstücks durchgeführt werden.

7. Verfahren nach einem der vorhergehenden Ansprüche, **dadurch gekennzeichnet, daß** die zweite Rauhigkeit weniger als 10 Å beträgt.

8. Verfahren nach einem der vorhergehenden Ansprüche, **dadurch gekennzeichnet, daß** die Feinbearbeitung so durchgeführt wird, daß der Oberfläche eine dritte Rauhigkeit verliehen wird, die geringer als die zweite Rauhigkeit ist.

9. Verfahren nach einem der vorhergehenden Ansprüche, **dadurch gekennzeichnet, daß** das Polieren das Abnehmen einer Schicht mit einer Dicke von zwischen 10 µm und 50 µm anwendet.

## Claims

1. A method of polishing at least one surface of a silicon-based part made of either SiO₂, SiC, glass, vitro-ceramic, or quartz, the method comprising:
a) a pre-polishing stage implementing at least one pre-polishing element and an abrasive, to confer a first roughness to said surface;
b) a polishing stage implementing at least one polishing element and a liquid containing a polishing abrasive to confer to said surface a second roughness that is smaller than the first roughness;
the method being **characterized in that** it comprises:
c) a finishing stage by soft abrasion implementing at least one finishing element, in particular a felt, and a soft abrasive, to remove a surface layer of sufficient thickness to improve the flux strength of the part, said thickness being not less than 1 µm.

2. A method according to claim 1, **characterized in that** the pre-polishing element is a cast iron plate and **in that** the abrasive is emery.

3. A method according to claim 1 or 2, **characterized in that** the polishing element is a polyurethane plate or pitch and **in that** the abrasive is an oxide, in particular of cerium or of zirconium.

4. A method according to any preceding claim, **characterized in that** the soft abrasive is constituted by colloidal silica.

5. A method according to claim 4, **characterized in that** the colloidal silica has particles of a size lying in the range 0.03 µm to 0.1 µm.

6. A method according to any preceding claim, **characterized in that** the silicon-based part is a plane part and **in that** the pre-polishing, polishing, and finishing stages are implemented on two opposite parallel plane faces of said plane part.

7. A method according to any preceding claim, **characterized in that** said roughness is smaller than 10 Å.

8. A method according to any preceding claim, **characterized in that** the finishing stage is performed in such a manner as to confer to said surface a third roughness that is smaller than said second roughness.

9. A method according to any preceding claim, **characterized in that** said polishing serves to remove a layer of thickness lying in the range 10 µm to 50 µm.
